# EUROPEAN PATENT SPECIFICATION

(11) **EP 3 189 915 B1**
(45) Date of publication and mention of the grant of the patent: **23.12.2020**
(21) Application number: 15832074.7
(22) Date of filing: 11.08.2015
(51) Int. Cl.: B22F 3/10, B22F 1/00, H01L 21/288, H01B 13/00

(54) **SINTERING DEVICE FOR METAL MATERIAL**
SINTERVORRICHTUNG FÜR METALLMATERIAL
DISPOSITIF DE FRITTAGE POUR MATÉRIAU MÉTALLIQUE

(30) Priority: 13.08.2014 JP 2014165032
(43) Date of publication of application: 12.07.2017
(73) Proprietor: National Institute of Advanced Industrial Science and Technology, Tokyo 100-8921 (JP)
(72) Inventor: SHIRAKAWA, Naoki, Tsukuba-shi Ibaraki 305-8565 (JP); MURATA, Kazuhiro, Tsukuba-shi Ibaraki 300-2635 (JP)
(74) Representative: Forstmeyer, Dietmar
(86) International application number: PCT/JP2015/072754
(87) International publication number: WO 2016/024586

(56) References cited:
- JP-A- 2004 250 283
- JP-A- 2008 272 609
- JP-A- 2009 200 158
- JP-A- 2011 047 003
- US-A1- 2010 178 437

## Description

### TECHNICAL FIELD

The present invention relates to a sintering device for metal fine particles.

### BACKGROUND ART

In a common method of industrially forming an electronic circuit, films of electronic materials, such as metal, semiconductor and insulator formed on one surface of a substrate are processed by photolithography. That is, processing is repeated in which a photoresist is applied onto the film, exposure and development are performed to leave the photoresist at portions required by the circuit, unnecessary electronic material is removed by etching, and the remaining photoresist is also removed. In such processing, a large amount of electronic material is wasted, and treatment of electronic and resist waste materials is also necessary, so that process entails high environmental load.

Consequently, from the viewpoint of resource and energy conservation, electronic circuit fabrication methods that utilize printing as a technology for depositing required amounts of materials at required places have recently attracted attention.

In such a technology, ink or paste containing metal fine particles is used to form the electronic circuit wiring, and a wiring pattern is formed on the substrate by one of various printing techniques, such as inkjet or screen printing. As this ink or paste is liquid, it therefore contains a solvent in addition to the metal fine particles, and generally further contains a dispersing agent for preventing aggregation of the metal fine particles, a binder for ensuring adhesion onto the substrate, and organic matter, such as the solvent for adjusting viscosity of the liquid. Accordingly, after the wiring pattern is formed, it is necessary to decompose these organic matters by heat treatment to form a conducting path among the metal fine particles. As the substrate on which printing is applied, plastics having flexibility are preferred, so that the heat treatment temperature must be lowered below the heat-resistance temperature limit of the plastic (for example, 200°C or so below).

Examples of resins having high heat resistance include polyimide (which can be used at 260°C or higher). However, polyimide is expensive in comparison with other plastics. Therefore, it is desirable to reduce the heat treatment temperature to about 180°C or lower, preferably 120°C or lower, so that use can be made of comparatively low cost plastics, for example, polyethylene naphthalate (PEN, maximum service temperature, about 180°C) or polyethylene terephthalate (PET, maximum service temperature, about 120°C).

With regard to an ink or paste containing fine particles of silver as metal, various products have been developed that can exhibit satisfactory electrical conductivity by applying low temperature heat treatment in the air (Patent Literature 1). Meanwhile, in the case of copper, if the heat treatment is applied in the air, copper oxide, which is an insulator, is formed, so that wiring having good electrical conductivity cannot be obtained. In order to avoid this problem, the ambience of the copper particles is required to be somehow made, at least locally, a reducing atmosphere during calcinating treatment.

As a means therefor, the following methods are known:
(1) heat treatment in a reducing gas of some kind, such as hydrogen (Non-Patent Literature 1), formic acid vapor (Patent Literature 2) or an ultralow oxygen atmosphere (Patent Literature 3, Patent Literature 4, Non-Patent Literature 2); and
(2) heat treatment upon using ink from which a reducing gas is generated from an ink component, such as copper formate, by thermal decomposition in an oxygen-blocked environment (Non-Patent Literature 3,

Patent Literature 5).

### CITATION LIST

### PATENT LITERATURES

Patent Literature 1: JP-A-2012-144795
Patent Literature 2: JP-A-2013-80919
Patent Literature 3: Japanese Patent No. 3921520
Patent Literature 4: Japanese Patent No. 4621888
Patent Literature 5: WO 2013/073349 A1

### NON-PATENT LITERATURES

Non-Patent Literature 1: Thin Solid Films 520 (2012) 2789.
Non-Patent Literature 2: Jpn. J. Appl. Phys. 52 (2013) 05DB19.
Non-Patent Literature 3: Mater. Res. Bull. 47 (2012) 4107.

JP 2008 272609 A discloses a processing system using an extremely low moisture gas for reducing moisture from the inner surface of the vacuum chamber to the limit, and a method for processing an object to be processed using the extremely low moisture gas. JP 2009 200158 A discloses depositing a thin film under an environment with extremely little water and oxygen, to form a high-dielectric insulating thin film and a silicon epitaxial film and to maximally reduce water that remains as impurities in the film. US 2010/0178437 A1 discloses an apparatus for generating gas having extremely low oxygen concentration, which supplies gas to a semiconductor manufacturing apparatus and the like, while the supplied gas is obtained by making the concentration of oxygen in the gas passing through the solid electrolyte of the apparatus to an extremely low level.

### SUMMARY OF INVENTION

### TECHNICAL PROBLEM

Some of the above-described conventional techniques use hydrogen, formic acid vapor or copper formate, but it is preferable to reduce environmental load, if possible, without relying on such a material. Moreover, in order to form a stable material having low resistivity in the air, it is preferable to allow grain growth or crystal growth of a metal material at a low temperature.

The present invention has been made in view of the above-described issues. Specifically, the present invention is contemplated for providing a device capable of: (1) when necessary, eliminating need for a gas component requiring disposal treatment; (2) effecting grain growth or crystal growth of the metal material at a low temperature; and (3) forming film or wiring having low resistivity.

### SOLUTION TO PROBLEM

That is, the present invention is defined in claim 1 and provides the following means:
[1] A sintering device for metal fine particles, comprising:
   an airtight container (1) for housing a specimen (6) thereinside;
   an oxygen pump (2) for extracting oxygen molecules from a gas discharged from the airtight container (1);
   a circulation means (3) for returning the gas into the airtight container (1); and
   a plasma generation means (4) present inside the airtight container (1) for converting the gas returned from the circulation means (3) into plasma and exposing the specimen (6) thereto;
   wherein the circulation means (3) is provided outside the airtight container (1); or
   wherein the circulation means (3) is provided inside the airtight container (1);
   wherein the plasma generation means (4) is an atmospheric pressure plasma unit that utilizes a total pressure of the gas returned from the circulation means and converted into plasma between 0.1 atm or more and less than 10 atm in terms of absolute pressure;
   wherein the atmospheric pressure plasma unit (4) comprises a voltage applying means (43) and a pipe (42) with electrodes (41a) and (41b) facing each other being fixed in a place near an outlet of the pipe (42) so that the plasma generated between the electrodes (41a) and (41b) can be blown onto the specimen (6) in the form of being jetted from the outlet of the pipe (42); or
   wherein the atmospheric pressure plasma unit comprises a high frequency and high voltage applying means in a position different from the outlet of the gas introduction pipe (42) to generate plasma by electromagnetic induction so that the plasma generated can be blown onto the specimen (6); and
   wherein the sintering device has a structure that forms a closed loop through which the used gas is returned to the oxygen pump (2).
[2] The device according to item 1, further comprising a heater (12) for heating the gas returned from the circulation means (3).
[3] The device according to item 1 or 2, comprising a specimen stage (7) for holding the specimen (6) inside the airtight container (1).
[4] The device according to item 3, wherein the specimen stage (7) includes a heater for heating the specimen.
[5] The device according to any one of items 1 to 4, wherein the circulation means (3) pressurizes the gas discharged from the airtight container (1) and returns the gas into the airtight container (1).
[6] The device according to any one of items 1 to 5, further comprising a nitrogen-containing gas feed path (9).
[7] The device according to any one of items 1 to 6, further comprising a partial pressure control unit that controls an oxygen partial pressure in the gas returned into the airtight container (1) to 10-25 atm or less.
[8] The device according to any one of items 1 to 7, wherein the oxygen pump (2) comprises a solid electrolyte body (21) having oxygen ion conductivity and electrodes (22, 23) arranged inside the body and outside the body.
[9] The device according to item 8, wherein the solid electrolyte body (21) is made of stabilized zirconia.
[10] The device according to item 8 or 9, wherein the electrode (22, 23) is a porous electrode along the surfaces of the solid electrolyte body (21).

### ADVANTAGEOUS EFFECTS OF INVENTION

A sintering device for metal fine particles of the present invention enables the metal fine particles to be processed by a new method. Moreover, according to the device of the present invention, (1) need for a gas component requiring disposal treatment can, when necessary, be eliminated; (2) grain growth or crystal growth of the metal fine particles constituting a raw material can be effected at a low temperature; and (3) a film having low resistivity can be formed.

Other and further features and advantages of the invention will appear more fully from the following description, appropriately referring to the accompanying drawings.

### BRIEF DESCRIPTION OF THE DRAWINGS

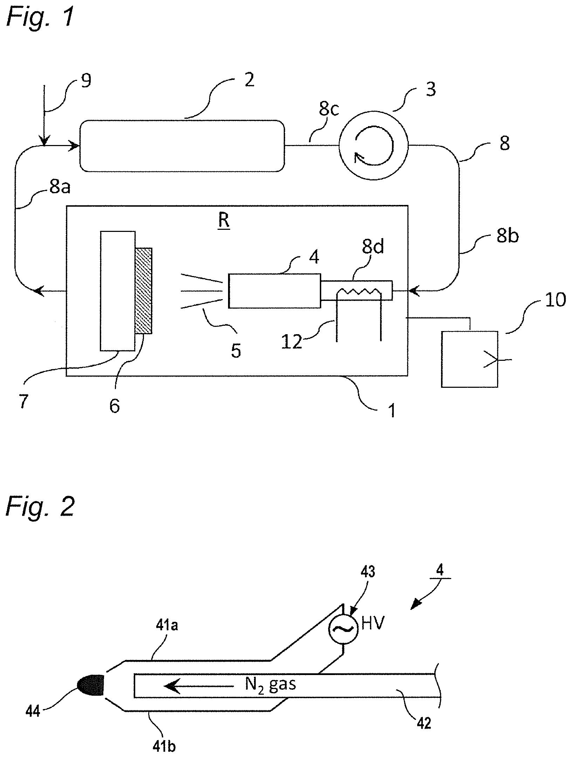

{Fig. 1}
   Fig. 1 is a device configuration diagram for describing a sintering device for metal fine particles, as related to a preferred embodiment of the present invention.
{Fig. 2}
   Fig. 2 is a side view schematically showing the plasma generation means.
{Fig. 3}
   Fig. 3 is a cross-sectional view schematically showing the heater for gas.
{Fig. 4}
   Fig. 4 is a cross-sectional view schematically showing a principal portion of the oxygen pump.
{Fig. 5}
   Fig. 5 is a cross-sectional view schematically showing the oxygen removal mechanism in the oxygen pump.
{Fig. 6}
   Fig. 6 is a device configuration diagram of a superfine fluid jet.
{Fig. 7}
   Fig. 7 is a plan view schematically showing a drawing pattern of the specimen (the membrane to be processed) of a metal material for use in Examples.
{Fig. 8}
   Fig. 8 is a drawing substitute photograph showing a scanning ion micrograph of a processed membrane (a sintered membrane) of the metal material prepared in Example 1.
{Fig. 9}
   Fig. 9 is a drawing substitute photograph showing a scanning ion micrograph of a processed membrane (a sintered membrane) of the metal material prepared in Example 3.
{Fig. 10}
   Fig. 10 is Fig. 1 (phase diagram) published in Patent Literature 4.
{Fig. 11}
   Fig. 11 is a drawing substitute photograph showing a scanning ion micrograph of a processed membrane of the metal material prepared in Comparative Example.

### MODE FOR CARRYING OUT THE INVENTION

Hereinafter, a sintering device for metal fine particles of the present invention will be described in detail based on Examples, but the invention should not be construed to be limited thereto.

### Sintering device]

Fig. 1 is a device explanatory diagram showing the whole of a sintering device for metal fine particles related to a preferred embodiment of the present invention. The device in this embodiment has an airtight container 1. Any kind of a material or quality of the material which constitutes the airtight container is acceptable, but metal, such as stainless steel, is ordinarily adopted. As a configuration thereof, the container is desirably a box-shaped container and has a structure in which an inside can be vacuumed. There are connecting pipes 8a, 8b and 8c between the airtight container 1 and an oxygen pump 2, between a circulation means 3 and the airtight container 1, and between the oxygen pump 2 and the circulation means 3, respectively, to form a circulating path 8 of gas. The gas discharged from the airtight container 1 passes through the oxygen pump 2, during which oxygen is removed into an ultralow oxygen state having an oxygen partial pressure of 10⁻²⁷ atm or less, for example. The oxygen pump and an oxygen removal mechanism thereinside will be described later. In this description, the oxygen partial pressure is to be measured by a zirconia-type oxygen partial pressure analyzer heated at 600°C, unless otherwise specified. A principle of operation of the zirconia-type oxygen partial pressure analyzer will be also described later. As the gas to be circulated, use can be made of an inert gas, such as nitrogen, argon or helium, but nitrogen is desirable mainly from a viewpoint of cost. Into the gas to be circulated, other components may be incorporated in the range in which advantageous effects of the present invention are not adversary affected. Specific examples of other components include hydrogen, carbon monoxide, carbon dioxide and a low-molecular-weight organic compound. The gas formed into the ultralow oxygen state is pressurized by the circulation means 3, passes through the pipe 8d inside the airtight container 1, and is delivered to a plasma generation means 4. A specimen stage 7 is provided inside the airtight container 1, and the gas converted into plasma is blown onto a specimen 6. The specimen 6 is a material prepared by depositing a film of the metal material on a substrate. At this time, an inside of a room R of the airtight container is filled with the above-described gas (gas formed into the ultralow oxygen state) to be circulated.

### [Plasma generation means]

The plasma generation means 4 is a so-called atmospheric pressure plasma unit, in which the gas is converted into plasma by glow discharge in the gas close to 1 atm. A structure of the plasma generation means 4 comprises, as shown in Fig. 2, a pipe 42 (8d) having an inner diameter of several millimeters, with electrodes 41a, 41b facing each other being fixed in a place near an outlet thereof. Plasma 44 in the form of being jetted from the outlet of the above-described pipe 42 (8d) can be generated by applying a voltage of several kilovolts to tens of kilovolts at tens of Hz to the electrodes 41a, 41b by using a voltage applying means 43. Alternatively, a configuration may be applied, in which a high frequency and high voltage applying means is provided in a position different from the outlet of the gas introduction pipe 42 (8d) to generate plasma by electromagnetic induction.

In consideration of conditions of generating the atmospheric pressure plasma and suitability of processing of the metal fine particles inside the above-described airtight container, a pressure inside the airtight container is adjusted to 0.1 atm or more and less than 10 atm, and more preferably to 0.5 atm or more and less than 2 atm. In a similar manner, a temperature inside the airtight container is adjusted preferably to 0°C or higher and 100°C or lower, and more preferably to 20°C or higher and 50°C or lower.

### [Specimen stage or the like]

The specimen 6 can be irradiated with plasma while the specimen 6 is heated by using a so-called hot plate as the specimen stage 7. In consideration of efficiency and suitability of processing of the metal material, a heating temperature at this time is adjusted preferably to 100°C or higher, more preferably to 120°C or higher, and particularly preferably to 180°C or higher. An upper limit thereof is adjusted preferably to 350°C or lower, more preferably to 300°C or lower, and particularly preferably to 250°C or lower. According to the present invention, the art of the present invention has an advantage of capability of processing of the metal material at a low temperature as described above. For example, when copper fine particles are used as the metal material, although a melting point thereof is over 1,000°C, voids on an interface of the fine particles or among the fine particles can be eliminated at 250°C or lower, and grain growth or crystal growth can be effected.

A period of time of processing the metal material only needs be appropriately set depending on a kind of the material and a thickness of the film. When processing is planned to be completed in a short period of time, for example, processing is performed preferably in 45 minutes or less, more preferably in 30 minutes or less, and particularly preferably in 20 minutes or less. As a lower limit thereof, processing in 10 minutes or more is practical.

### [Heater for gas]

On the other hand, in a technology on atmospheric pressure plasma to be applied upon converting the gas into plasma, an average temperature of gas molecules converted into plasma is typically about 80°C, which is lower than a temperature of the hot plate. If the specimen is irradiated with the gas molecules converted into plasma at such a low temperature, a surface of the specimen is eventually cooled. Consequently, a temperature setting of the hot plate needs be so that a temperature lowering caused by blowing of atmospheric pressure plasma can be compensated, and therefore a substrate that can be used is limited.

In order to solve this problem, a heater 12 for gas is provided in a previous stage of the plasma generation means 4. The gas is warmed by the heater 12 for gas, and then converted into plasma. Thus, cooling of the surface of the specimen by blowing plasma can be prevented.

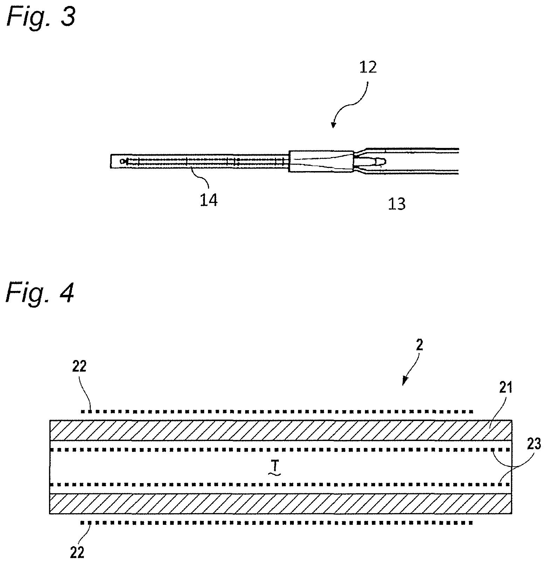

As the heater 12 for gas, use can be conveniently made of a hot air heater, as shown in Fig. 3, which is sold from Heat-Tech, Co., Ltd. or the like. In the hot air heater, a heater element 14 for heating the gas is arranged around a gas flow path deep from a gas inlet 13.

In Fig. 1, the heater 12 for gas is present inside the airtight container 1, but can also be provided on the way of the pipe 8b.

Plasma has a finite lifetime, and therefore it is not expedient to significantly separate the plasma generation means 4 from the specimen 6. It is considered to be more advantageous that the gas is warmed by the heater 12 for gas, and then converted into plasma. As long as the distance between the plasma generation means 4 and the specimen 6 is short enough for the efficiency of plasma, positions of the heater 12 for gas and the plasma generation means 4 may be interchanged.

### [Circulation means]

In Fig. 1, the circulation means 3 is provided outside the airtight container 1, but can be provided inside the airtight container 1. In such a configuration, even if airtightness of the circulation means 3 is insufficient, an ultralow oxygen partial pressure state can be maintained. On the other hand, the airtight container 1 needs a size enough to have the circulation means 3 built-in. Therefore, a system configuration is preferably selected, by comparing a fabrication cost of the larger airtight container 1 with a cost required for achieving airtightness of the circulation means 3.

A gas circulation flow rate within the system is not particularly limited, but from viewpoints of generation of plasma and satisfactory processing inside the airtight container 1, the flow rate is preferably 1 L/min or more, more preferably 2 L/min or more, and particularly preferably 3 L/min or more. An upper limit thereof is preferably 10 L/min or less, more preferably 7 L/min or less, and particularly preferably 5 L/min or less. When a plurality of the plasma generation means 4 are provided inside the airtight container 1, the above-described flow rate is preferably adjusted in conforming to the number thereof. For example, the gas circulation flow rate is preferably adjusted in the range in which the number of plasma generation means 4 (plasma torches) is multiplied by the flow rate specified as described above.

### [Oxygen pump]

The oxygen pump 2 according to the present invention is preferably equipped with a solid electrolyte body having oxygen ion conductivity and electrodes arranged inside and outside the body.

Fig. 4 is a principal portion cross-sectional view schematically showing the oxygen pump (an oxygen molecule discharging unit) 2 in Fig. 1. The oxygen pump 2 is provided with a zirconia solid electrolyte body (a solid electrolyte body) 21 having oxygen ion conductivity, and porous electrodes 22, 23 which are composed of gold or platinum, and which are arranged on an inner surface and an outer surface thereof. The zirconia solid electrolyte body 21 is fixed, by brazing, with a metal tubular member (not shown) composed of a Kovar material in both end portions. The tubular member and the electrode of the solid electrolyte body configure an inner electrode. An internal pressure in the oxygen molecule discharging unit is adjusted preferably to 0.5 kg/cm² or less, and more preferably to 0.2 kg/cm² or less, in terms of a gauge pressure. A lower limit thereof is preferably adjusted to 0.1 kg/cm² or more.

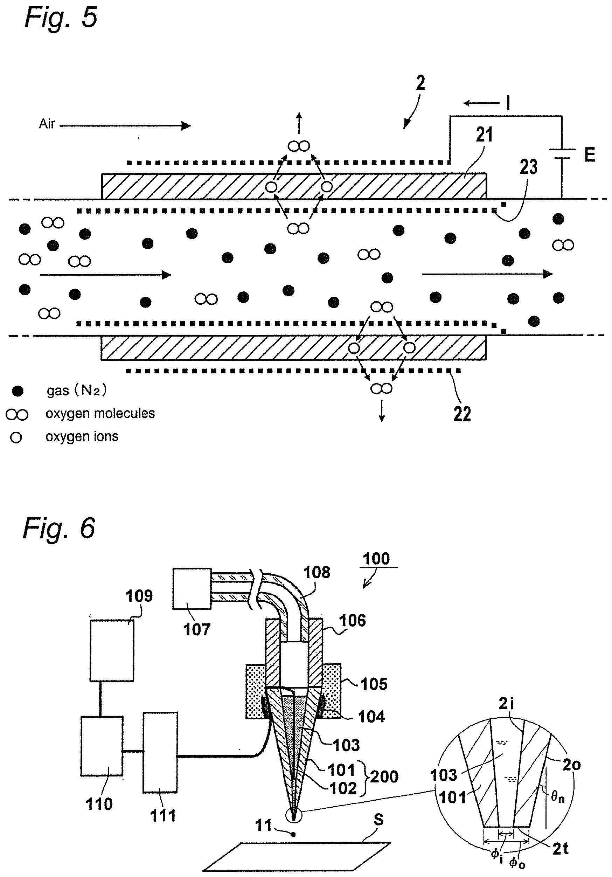

Fig. 5 is a cross-sectional view schematically showing operation of the oxygen pump 2. An electric current I is passed through a space between the porous electrode (an inner surface electrode) 23 and the porous electrode (an outer surface electrode) 22 from a DC power supply E. Then, oxygen molecules (O₂) existing in a space T inside the solid electrolyte body 21 are electrolyzed by the inner surface electrode 23 into two oxygen ions, which pass through the solid electrolyte body 21. Then, the oxygen ions are again formed as the oxygen molecules (O₂), and emitted to an outside of the solid electrolyte body 21. The oxygen molecules emitted to the outside of the solid electrolyte body 21 are swept away with an auxiliary gas, such as air, as a purge gas. According to the above-described process, the oxygen molecules in the inert gas (for example, N₂) to be fed to the solid electrolyte body 21 are removed, and the oxygen partial pressure can be reduced or controlled.

Thus, according to the oxygen pump 2 (the oxygen molecule discharging unit), the oxygen molecules in the gas are discharged to outside air while the gas introduced into the solid electrolyte body (hereinafter, also referred to as a solid electrolyte tube) 21 passes through the solid electrolyte body 21. As a result, the gas having a extremely low oxygen partial pressure is formed, and can be fed from the solid electrolyte body 21 toward the airtight container 1 (Fig. 1). In Fig. 5, a symbol '●' schematically shows a carrier gas (N₂ or the like), a symbol '○○' schematically shows oxygen molecules, and a symbol '○' schematically shows oxygen ions.

The oxygen partial pressure in the gas can be set to 10⁻²⁵ atm, for example. Specifically, a control signal for setting the present value to a value set by a setting unit is transmitted from a partial pressure control unit (not shown) to the oxygen pump 2. A voltage E of the oxygen pump 2 is controlled by the control signal. Then, the oxygen partial pressure in the inert gas, such as N₂, Ar or He, which is fed to the oxygen pump 2 through a gas feed valve and a mass flow controller (not shown), is controlled to the value set by the setting unit (not shown).

The inert gas in which oxygen is controlled to the extremely low oxygen partial pressure as described above is preferably fed, after the partial pressure is monitored by a sensor, to the plasma generation means inside the airtight container. The monitored value is input into an oxygen partial pressure control unit, and is compared with a set value in an oxygen partial pressure setting unit. Thus, the inert gas in which the oxygen partial pressure is controlled to a level 10⁻²⁵ atm or less is fed thereto. On the other hand, the oxygen partial pressure of the gas to be exhausted from the airtight container is monitored by the sensor, and serves as an indicator of an oxygen evacuation speed from the specimen inside the airtight container. It is necessary to form a closed loop through which the used gas is again returned to the oxygen pump. The oxygen partial pressure can be determined from the Nernst equation by using an oxygen sensor in which an oxygen ion conductor is used. A basic structure of the oxygen sensor is a tube (a solid electrolyte tube) itself of the zirconia solid electrolyte body 21 having oxygen ion conductivity, provided with the porous electrodes 22, 23 which are composed of gold or platinum, and which are arranged on the inner surface and the outer surface thereof, as shown in Fig. 4. Fig. 5 shows a use example as the oxygen pump. In place of applying the voltage E from outside, a potential difference E between the inner surface electrode 23 and the outer surface electrode 22 is measured by using a potentiometer. Thus, the oxygen partial pressure p(O₂) of the gas inside the solid electrolyte tube 21 is determined from a formula: 4FE=RTIn[0.21/p(O₂)]. Unless otherwise specified, a sensor temperature is set to 600°C. Here, F denotes the Faraday constant, R denotes the gas constant, and T denotes an absolute temperature of the solid electrolyte tube 21.

As a solid electrolyte which constitutes the solid electrolyte body 21, a zirconia-based material represented by a formula: (ZrO₂)_{1-x-y}(In₂O₃)ₓ(Y₂O₃)_{y} (0 < x < 0.20, 0 < y < 0.20, 0.08 < x + y < 0.20) can be utilized, for example.

As the solid electrolyte, in addition to the materials exemplified above, for example, such a material can be adopted as a complex oxide containing Ba and In, and a material in which part of Ba in this complex oxide is subjected to solid solution substitution with La;

in particular, a material in which a ratio of the number of atoms {La/(Ba + La)} is adjusted to 0.3 or more.

Further, such a material can be adopted as a material in which part of In is replaced by Ga,
for example, a material represented by a formula: {Ln₁₋ₓSrₓGa_{1-(y + z})Mg_{y}Co_{z}O_{3-d}, in which Ln = one kind or two kinds of La, Nd; x = 0.05 to 0.3; y = 0 to 0.29; z = 0.01 to 0.3; y + z = 0.025 to 0.3};
a material represented by a formula: {Ln₁₋ₓAₓGa_{1-y-z}B1_{y}B2_{z}O_{3-d}, in which Ln = one kind or two or more kinds of La, Ce, Pr, Nd, Sm; A = one kind or two or more kinds of Sr, Ca, Ba; B1 = one kind or two or more kinds of Mg, Al, In; B2 = one kind or two or more kinds of Co, Fe, Ni, Cu};
a material represented by a formula: {Ln₂₋ₓMₓGe_{1-y}LyO_{5-d}, in which Ln = La, Ce, Pr, Sm, Nd, Gd, Yd, Y, Sc; M = one kind or two or more kinds of Li, Na, K, Rb, Ca, Sr, Ba; L = one kind or two or more kinds of Mg, Al, Ga, In, Mn, Cr, Cu, Zn; a material represented by a formula: {La₁₋ₓSrₓGa_{1-y-z}Mg_{y}Al₂O_{3-d}, in which 0 < x ≤ 0.2; 0 < y ≤ 0.2; 0 < z < 0.4}; and
a material represented by a formula: (La₁₋ₓAₓGa_{1-y-z},B1_{y}B2_{z}O_{3-d}, in which Ln = one kind or two or more kinds of La, Ce, Pr, Sm, Nd; A = one kind or two or more kinds of Sr, Ca, Ba; B1 = one kind or two or more kinds of Mg, Al, In; B2 = one kind or two or more kinds of Co, Fe, Ni, Cu; x = 0.05 to 0.3; y = 0 to 0.29; z = 0.01 to 0.3; y + z = 0.025 to 0.3}.

A connection structure between both end portions of the solid electrolyte body 21 and the tubular member influences the oxygen partial pressure, and therefore it is preferable to ensure high airtightness. For this purpose, it is preferable to adopt bonding or joining, by brazing metal, of the tubular member and the solid electrolyte body 21. In order to develop ion conductivity, the solid electrolyte is preferably heated to 600°C to 1,000°C. In order to increase a discharging speed at the oxygen pump, the solid electrolyte is preferably heated to a higher temperature. The oxygen pump may be applied in one unit or a plurality of units in the system. Usually, a molecule discharging function is enhanced as the solid electrolyte body 21 becomes longer. On the other hand, if cost and handling are taken into consideration, a length of 15 cm to 60 cm is preferable. A length of each tubular member to be connected is desirably 3 cm to 60 cm on one side thereof. To a connecting portion between the solid electrolyte body 21 and the tubular member, electrolytic plating by gold or platinum is preferably applied after brazing. Further, an electrolytic plating part is pretreated by acid or alkali, and then electroless platinum plating is preferably simultaneously applied also to the solid electrolyte body. Thus, the resulting material functions as the porous electrode.

In the present invention, an oxygen partial pressure in the gas to be circulated is preferably 10⁻²² atm or less, more preferably 10⁻²³ atm or less, further preferably 10⁻²⁵ atm or less, and particularly preferably 10⁻²⁷ atm or less. A lower limit thereof is not particularly limited, but is practically 10⁻³⁰ atm or more.

With regard to the configuration of the oxygen pump 2 and the circulation means 3 mentioned above, the configuration listed, for example, in the above-described Patent Literature 3 can be preferably applied.

### [Metal material]

The metal material to be applied thereto in the present invention is fine particles of metal or a metal compound. Above all, the metal material is preferably electrical-conductive fine particles (powder). The metal material is preferably particles of transition metal or transition metal oxide, and is preferably a material to be formed into metallic transition metal in the process of metallization of electrical-conductive ink. The metal material is preferably subjected to processing according to the present invention in a state of the fine particles (powder) to achieve grain growth or crystal growth through the processing to integration. For example, a dense layer of the metal material is configured by achieving such the integration. This dense layer is considered to be applied to adhesion between the substrate and a wiring layer, or to fabrication for obtaining electrical conduction. Thus, physical properties are stabilized by achieving integration (bulk) of the metal particles. For example, the integrated metal particles are not oxidized, which is different from the fine particles, and a low electrical resistance state can be preferably maintained, even in the air.

The metal material is not particularly limited as long as the advantageous effects of the present invention can be obtained. In addition to the metal per se, such as the above-mentioned transition metal, oxide thereof and a complex compound thereof, can also be used.

Specific examples of kinds of metal to be used for the metal material include: copper, gold, platinum, silver, ruthenium, palladium, rhodium, iron, cobalt, nickel, tin, lead, bismuth, and an alloy thereof. Above all, copper, silver, iron, nickel or ruthenium is preferably used, and copper is particularly preferably used. To add a supplemental explanation in this regard, specific examples include silver being expensive and apt to cause migration (electromigration, ion migration). In contrast, fine particles of copper are inexpensive, and high in migration resistance. Therefore, it is preferable to use a technology on forming a wiring by printing, using ink or paste containing copper. However, the present invention should not be construed to be limited thereto by the above-described description.

The metal material can be prepared in the form of particles and used. A primary particle diameter (an average particle diameter) of the fine particles of the metal material is preferably 1 nm or more, more preferably 10 nm or more, and particularly preferably 20 nm or more. An upper limit thereof is preferably 2,000 nm or less, and more preferably 1,500 nm or less. As a further preferable upper limit, the particle diameter is preferably 1,000 nm or less, more preferably 500 nm or less, and further preferably 200 nm or less. As a still further preferable upper limit, the particle diameter is further preferably 100 nm or less, still further preferably 80 nm or less, and particularly preferably 50 nm or less. A specific surface area can be expanded and the number of contacts of the particles with each other can be increased, by adjusting the particle diameter of the primary particles of particles of the metal material to the above-described range, which is preferable. Alternatively, such a range is preferable in view of capability of effectively maintaining dispersibility of the particles in the ink and homogeneity of the film.

In this description, a primary particle diameter of the metal material means a modal particle diameter (300 to 1,000 pieces are measured in one evaluation specimen) measured by applying a particle size distribution measurement method by analysis of a transmission electron microscope image. A concentration of the metal material in a measurement specimen is adjusted to 60 mass%, unless otherwise specified. As the solvent at this time, a commonly used solvent can be used.

### [Dispersing agent]

When the product is formed into the ink containing fine particles of the metal material, a dispersing agent is preferably incorporated thereinto. The dispersing agent is preferably a dispersing agent having an acidic anchoring group (or a salt thereof), such as a carboxyl group, a sulfo group and a phosphate group. Specific examples of a commercially available dispersing agent include: Disper BYK 110, Disper BYK 111, Disper BYK 180, Disper BYK 161, Disper BYK 2155 (trade names for all, manufactured by BYK Japan KK), and DISPARLON DA-550, DISPARLON DA-325, DISPARLON DA-375 , DISPARLON DA-234, DISPARLON PW-36, Disparlon 1210, Disparlon 2150, DISPARLON DA-7301, DISPARLON DA-1220, DISPARLON DA-2100, DISPARLON DA-2200 (trade names for all, manufactured by Kusumoto Chemicals, Ltd.).

The dispersing agent in the ink is preferably contained in an amount of 0.1 part by mass to 1 part by mass based on 100 parts by mass of the metal material fine particles. If this amount is excessively small, such an amount is insufficient to uniformly disperse the electrical-conductive fine particles thereinto, and if the amount is excessively large, such an amount causes lowering of characteristics of a processed film of the metal material.

### [Medium]

The solvent in a dispersion (ink) containing the metal material is not particularly limited, but is preferably a solvent which is able to sufficiently disperse the above-described metal material therein. For example, an aromatic hydrocarbon, such as xylene and toluene, or an aliphatic hydrocarbon, such as butadiene and normal hexane, are suitable in view of handling property. When the ink is jetted according to an inkjet method, the ink is preferably flowable and is able to be jetted from a nozzle. The ink may be in absence of any solvent depending on the method.

When the product is formed into a dispersing element (ink) in which the metal material is dispersed in the medium, a concentration thereof may be appropriately adjusted. Specific examples include setting to a concentration suitable for jetting the ink by a superfine fluid jet as described later. A concentration of the metal material in the ink is preferably 50 mass% or more and 80 mass% or less, and more preferably 60 mass% or more and 70 mass% or less.

### [Processed membrane of metal material]

The metal material processed by the device of the present invention is preferably formed in the form of the film. A thickness of this processed membrane (a membrane after the metal material is processed) is different depending on an application. For example, when utilization as an electronic material is taken into consideration, the thickness of the processed film is preferably 1 µm or more, more preferably 2 µm or more, and further preferably 5 µm or more. An upper limit thereof is not particularly limited, but is practically adjusted to 20 µm or less, and may be adjusted to 10 µm or less.

When the ink containing fine particles of the metal material is used, the film to be processed (a film before being processed) can be formed by applying the ink onto the substrate by the superfine fluid jet or the like as described later. As the film to be processed, the applied film may be directly used, but it is preferable to apply preprocessing by heating in order to remove a redundant medium component. A heating temperature of preprocessing only needs be adjusted depending on the metal material or the medium. Specific examples include adjustment of the heating temperature to 80°C or higher and 250°C or lower.

As the metal material, as mentioned above, the material in the form of fine particles is used. At this time, a surface of the particles may be in an oxidized state before processing. That is, the metal material may be metal oxide. A whole of the metal material (metal fine particles) is reduced through processing in the present invention. According to this reducing action, electrical resistivity of the metal material, for example, when the material is formed in the film can be reduced to a degree comparable with a level when the material is not oxidized.

An internal structure of the processed film of the metal material is not particularly limited, but is preferably an integrated structure without a remainder of the fine particles and/or voids among grown particles. According to the present invention, even upon using the fine particles as the material, grain growth and crystal growth can be effectively accelerated into the film having a dense metallographic structure. The electrical resistivity of the processed film is not particularly limited, but the film is preferably processed to the film having resistivity close to intrinsic resistivity of the metal to be processed. For example, when the metal to be processed is copper, the electrical resistivity is adjusted preferably to100 µΩ•cm or less, more preferably to 50 µΩ•cm or less, and further preferably to 20 µΩ•cm or less. Further, the electrical resistivity is adjusted still further preferably to 8 µΩ•cm or less, furthermore preferably to 5 µΩ•cm or less, and particularly preferably to 3 µΩ•cm or less. A lower limit thereof is 1.7 µΩ•cm being a physical property value of bulk. In terms of a relationship with the intrinsic resistivity of the metal material, the resistivity is preferably 50 times or less the intrinsic resistivity, more preferably 30 times or less the intrinsic resistivity, and further preferably 10 times or less the intrinsic resistivity. Further, in terms of the relationship with the intrinsic resistivity of the metal material, the resistivity is preferably 5 times or less the intrinsic resistivity, more preferably 3 times or less the intrinsic resistivity, and particularly preferably 2 times or less the intrinsic resistivity. The value of the electric resistivity in this specification means a value measured at room temperature (about 25°C) by the method presented in Examples, unless otherwise specified.

The descriptions relating to the superfine fluid jet at paragraphs {0036} to {0046} do not form part of the invention, but represent background art that is useful for understanding the invention.

### [Superfine fluid jet]

The metal material applied to the device of the present invention may be applied on the substrate by any methods upon processing thereof. Specific examples include application by various methods, such as an inkjet method, a spin coating method and a screen applying method. In the present invention, above all, processing by the superfine fluid jet is preferable.

Fig. 6 is an explanatory diagram schematically showing a superfine fluid jet device (super inkjet) 100 to be used as one embodiment in the present invention. In the superfine fluid jet device 100 in this embodiment, a superfine diameter nozzle (super fine nozzle member) 200 is composed of a nozzle body 101 and an electrode 102. Upon considering achievement of superfine liquid droplet size, the nozzle body 101 is preferably formed into one having low conductance. For this purpose, a glass capillary is preferable. In addition to that, one prepared by coating an electrical-conductive substance with an insulating material can also be applied.

A lower limit of an opening diameter (a diameter of a circle equivalent in the projected area of the opening in interest, i.e. an equivalent circle diameter) ϕᵢ at a tip of the superfine nozzle 200 (the nozzle body 101) is preferably 0.01 µm for convenience of fabrication of the nozzle. As an upper limit, a nozzle inner diameter ϕᵢ is adjusted preferably to 20 µm or less, more preferably to 10 µm or less, further preferably to 8 µm or less, and particularly preferably to 6 µm or less. An outer diameter ϕₒ (the equivalent circle diameter) at the tip of the superfine nozzle is not particularly limited, but the outer diameter ϕₒ is adjusted preferably to 0.5 µm to 20 µm, and more preferably to 1 µm to 8 µm, in consideration of a relationship with the above-described opening diameter ϕᵢ and occurrence of a satisfactory concentration electric field at a nozzle tip 2t.

The superfine nozzle 200 (the nozzle body 101) in this embodiment has a taper, and a configuration of being tapered toward to the nozzle tip 2t. In the nozzle shown, the configuration is shown in terms of a taper angle θₙ of a nozzle profile 2o relative to a direction of an inner pore of the nozzle. This angle θₙ is preferably 0° to 45°, and more preferably 10° to 30°. A nozzle inner form 2i is not particularly limited, but only needs be in a configuration formed in an ordinary capillary tube in this embodiment. The inner form may be in a tapered shape somewhat tapered along the taper of the above-described profile. However, the nozzle body 101 which constitutes the superfine nozzle 200 is not limited to the capillary tube, and is allowed to be in a configuration to be a shape formed by microfabrication.

In this embodiment, the nozzle body 101 which constitutes the superfine nozzle 200, is formed of a glass having good shapability. A metal wire (i.e., tungsten wire) 102 is inserted, as an electrode, into an inside of the nozzle body 101. As a modified example, in place of that, the electrode may be formed inside the nozzle by plating, for example. As a further modified example, when the nozzle body 101 per se is formed of the electrically conductive substance, an insulating material may be coated thereon. Moreover, a liquid 103 to be jetted is filled inside the superfine nozzle 200. On the above occasion, in this embodiment, the electrode 102 is arranged so as to be dipped in the liquid 103, and the liquid 103 is fed from a liquid source (not shown).

In this embodiment, the superfine nozzle 200 is attached to a holder 106 by a shield rubber 104 and a nozzle clamp 105 to allow no leakage of pressure. The pressure regulated by a pressure regulator 107 is transmitted to the superfine nozzle 200 through a pressure tube 108. As a role of the pressure regulator 107 in this embodiment, the pressure regulator 107 can be used for extruding the fluid from the superfine nozzle 200 by applying a high pressure thereto. Then, the pressure regulator 107 is particularly effective for use in regulating conductance, filling a liquid containing an adhesive into the superfine nozzle 200, and eliminating nozzle clogging, or the like. Moreover, the pressure regulator 107 is also effective for controlling a position of a liquid level, or forming a meniscus. Further, the pressure regulator 107 may be used so as to assume a role of controlling a microjet amount by controlling force worked on the liquid 103 inside the nozzle by providing a phase difference from a voltage pulse.

### (Control of voltage application)

In this embodiment, a jet signal from a computer 109 is transmitted to a generator (a voltage applying means) 110 of a voltage having a predetermined waveform, for control. The voltage generated from the generator 110 of the voltage having a predetermined waveform is transmitted to the electrode 102, through a high-voltage amplifier 111. The liquid 103 inside the superfine nozzle 200 is charged by this voltage. In this embodiment, utilization are made of: a concentration effect of an electric field at a nozzle tip portion; and action of image force to be induced in a counter substrate. Therefore, it is unnecessary to apply a conductive material as a substrate S, or provide a electrically-conductive counter substrate aside therefrom. That is, various materials including an insulating material can be used as the substrate S depending on circumstances. The voltage applied to the electrode 102 may be of a direct current or an alternating current, and may be either positive or negative.

As a distance between the superfine nozzle 200 and the substrate S is shorter, the image force is further worked, and therefore impact accuracy is improved. If the impact accuracy and vibration of the substrate S are taken into consideration, the distance between the superfine nozzle 200 and the substrate S is adjusted preferably to 1,000 µm or less, and more preferably to 500 µm or less. Further, the distance is adjusted further preferably to 100 µm or less, still further preferably to 50 µm or less, and particularly preferably to 30 µm or less. A lower limit thereof is not particularly limited, but is practically 1 µm or more or 10 µm or more.

According to the superfine fluid jet device 100 in this embodiment, such the superfine liquid droplets 11 can be jetted as micronized to a level difficult by a conventional piezo-type inkjet or a Bubble Jet (registered trademark)-type inkjet. Therefore, the droplets can be continuously jetted, and hit thereon, and a linear drawing pattern can be formed. In this superfine liquid droplets 11, an evaporation speed is significantly high, by action of surface tension, a high level of a specific surface area, and the like. Accordingly, it is considered that satisfactory film formation can be implemented, by suitably controlling evaporation-and-drying of the liquid droplets, collision energy, electric field concentration, and the like. Moreover, it is also an advantage of this embodiment that even the liquid droplets mass of which is rapidly lost by drying and solidification as described above can be accurately impacted onto desired positions, without losing control, by action of electric field concentration and a line of electric force generated between the substrate S and the nozzle.

Strength of the electric field, which allows jetting and which is generated at the tip 2t of the superfine nozzle 200, is not based on the electric field determined only by a voltage V to be applied to the nozzle, and a distance h between the nozzle and the counter electrode. It is understood that the above-described strength of the electric field is rather based on strength of a local concentration electric field at the nozzle tip 2t. Moreover, an important matter in this embodiment is that a local strong electric field and the flow path through which the fluid is fed have significantly small conductance. Then, the fluid per se is sufficiently charged in a micro area. If a dielectric, such as the substrate, or a conductor, is brought close to the charged micro fluid, the image force is worked, and the charged micro fluid flies perpendicularly to the substrate, impacted thereon, to form a coating film or a fine line, which is formed into a fine line drawing pattern. For a principle of jetting the superfine liquid droplets to be realized by the above-described superfine fluid jet device 100 and a preferred embodiment thereof, JP-A-2004-165587 can be further referred to.

In order to realize satisfactory liquid droplet jetting, an electrical state on a side of the substrate S is preferably formed into a preferred state so that a sufficient potential difference is produced between the superfine nozzle 200 and the substrate S. Specific examples include: adaptation for producing the sufficient potential difference between the nozzle and the substrate, by using a electrically-conductive member in part of the device, to ground the member, or connecting the member to a power supply unit having polarity opposite to the polarity of the electrode to be connected to the nozzle of a power supply. By this potential difference, the charged liquid droplets can be flied along the line of electric force between the substrate and the nozzle, and can be securely deposited onto the substrate.

The electric current to be applied may be of a direct current or an alternating current. The voltage (the potential) is preferably set lower from a viewpoint of workability and power saving. Specifically, the voltage is preferably 5,000 V or less, more preferably 1,000 V or less, further preferably 700 V or less, and particularly preferably 500V or less. A lower limit thereof is practically 100 V or more, and further practically 300 V or more. A pulse width is adjusted preferably to the same level or more with regard to the time to be calculated from a slew rate of the power supply (amplifier) to be used, and more preferably to 2 times or more. An upper limit thereof is preferably in the range of 100 times or less, and more preferably in the range of 10 times or less. Specifically, a width of one pulse is preferably 0.00001 second or more, more preferably 0.0001 second or more, and particularly preferably 0.001 second or more. An upper limit thereof is preferably 1 second or less, more preferably 0.1 second or less, and further preferably 0.01 second or less. A waveform of the pulse is not particularly limited, but may be a sine wave or a rectangular wave. In the present invention, the waveform is adjusted preferably to the rectangular wave, in consideration of controllability. A frequency in the case of jetting the droplets by AC is practically 100 Hz or more, and further practically 1,000 Hz or more, in consideration of the above-described jetting controllability. An upper limit thereof is adjusted preferably to 10,000 Hz or less, and more preferably to 100,000 Hz or less.

The above-described setting values are not determined only by the applied voltage, but may be appropriately set according to physical properties of the liquid to be adopted, the nozzle diameter, the volume inside the nozzle, the distance between the nozzle and the substrate, or the like.

According to the superfine fluid jet device 100, the film of the metal material in the significantly fine configuration can be efficiently formed in an on-demand manner. A line width or a dot diameter of the membrane of the metal material is preferably 30 µm or less, more preferably 10 µm or less, and particularly preferably 5 µm or less, in the case of forming fine patterns. A lower limit thereof is not particularly limited, but is practically 500 nm or more. However, a line or a dot having a larger width may be formed by processing such as recoating. Moreover, according to the above-described superfine fluid jet device 100, a three-dimensional structure can be formed, in which fine drawing objects are stacked in a height direction. A height of the structure is not particularly limited. When such a height is realized, the height is adjusted preferably to 1 µm or more, more preferably to 3 µm or more, and particularly preferably to 5 µm or more. An upper limit thereof is not particularly limited, but is practically 10 µm or less. An aspect ratio of the three-dimensional structure (height of the three-dimensional structure/length of the shortest part on a bottom surface) is adjusted preferably to 0.5 or more, more preferably to 1 or more, and particularly preferably to 3 or more. An upper limit thereof is not particularly limited, but is practically 5 or less.

In the following, each advantage of the preferred embodiment in the present invention will be described, including a comparison with a publicly-known art. However, the present invention should not be construed to be limited thereto.

In the technology in the above-described Non-Patent Literature 3, copper formate is used, as an ink raw material, into a configuration in which copper particles produced by decomposition are linked by necking, and in which no grain growth is observed. In Non-Patent Literature 1 and Patent Literature 2, heat treatment is applied under a reducing atmosphere of hydrogen and formic acid vapor. Here, grain growth to some extent is observed, but a relative growth of a grain diameter is about several times, and is insufficient. Resistivity is also limited to about 5 µΩ•µm at a minimum. If grain growth is insufficient, copper is spontaneously oxidized in the air, and the resistivity is to be increased with the lapse of time.

In conventional reduction heat treatment (without using plasma) using an ultralow oxygen atmosphere, processing at a low temperature can be made (Patent Literature 4), but almost no grain growth is observed in the processed film.

According to the preferred embodiment of the present invention, it does not use a gas that requires disposal treatment (treatment for discharging (purging) or recovery), such as hydrogen and formic acid vapor. Moreover, the metal material can be efficiently processed at a low temperature, for example, 180°C or lower, in a short period of time, by using an inert gas, such as nitrogen.

According to the preferred embodiment of the present invention, as mentioned above, not only reduction of the metal material but also grain growth or crystal growth is realized. Thus, the electrical resistivity of the film can be significantly lowered, and the present invention can be preferably adapted for production of the electrode, the wiring, and the like, of an electronic device.

According to the preferred embodiment of the present invention, the necessity is eliminated of using the ink, in which a raw material contains, for example, copper formate, generating a reducing gas, and the present invention can extend a degree of freedom of ink selection.

According to the preferred embodiment of the present invention, the inert gas, such as nitrogen, is provided with reducing performance through the oxygen pump, and therefore there exists no necessity of using such the ink as generating the reducing gas, due to thermal decomposition of the raw material. Therefore, in preparation of the ink, use can be positively made of materials related to improvement of printing quality, such as the metal fine particles and the dispersing agent, the solvent, and the viscosity modifier.

According to the preferred embodiment of the present invention, particularly when copper nanoparticles are used as the metal fine particles, a specimen having low resistivity within twice the resistivity of bulk copper can be obtained by processing at a temperature of 180°C or lower, in a short period of time. Therefore, such a specimen can be applied to a plastic substrate, or the like. Moreover, the processed film formed of grains grown to an order of µm can be formed, and therefore even if the film is allowed to stand, for example, for several months, at room temperature, in the air, a rise of resistivity can be suppressed.

### EXAMPLES

The present invention will be described in more detail based on examples given below, but the invention is not meant to be limited by these.

### [Example 1]

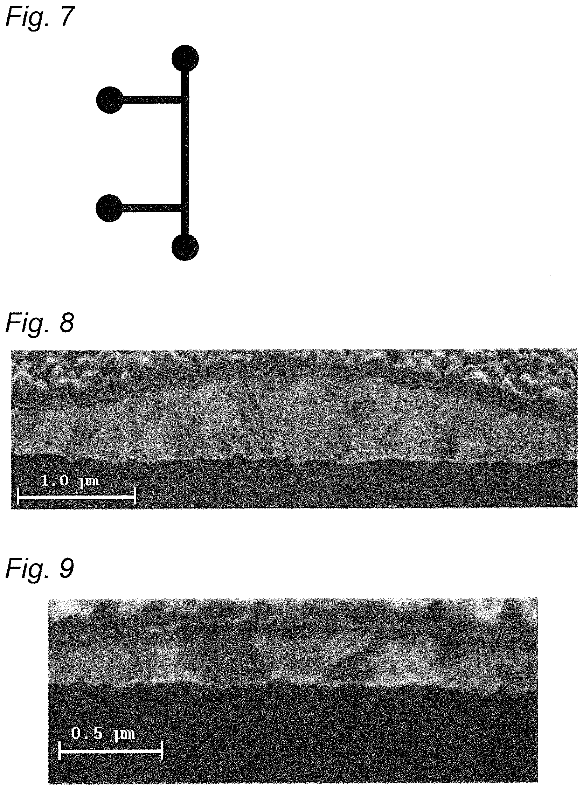

A specimen was prepared, in which a thin line having a width of about 7 µm and a length of 10 mm was drawn in a pattern, as shown in Fig. 7, by using copper ink, on a glass substrate. The copper ink used was a material prepared by dispersing copper fine particles having about 20 nm into a solvent, and the ink was jetted by a superfine inkjet printer (Fig. 6) to be stacked to a thickness of about 1 µm, by repeatedly drawing with the ink for several times.

The copper ink manufactured by lox Co., Ltd. (copper concentration, 60 mass%) was used.

Then, the specimen on which the ink pattern was drawn was calcinated at 250°C for 30 minutes under an oxygen flow. At this stage, the thin line of copper being the specimen turned into black having gloss. If a so-called solid film in which the copper ink is applied in a wide area is processed under the same conditions, it is confirmed by X-ray diffraction that copper is almost changed to copper oxide. Accordingly, it is assumed that the above-described thin line of copper would be also changed to copper oxide.

This specimen was fixed to the specimen stage 7 together with the glass substrate, and a lid was placed on the airtight container 1, and an inside of the container 1 was vacuumed by the vacuum pump 10. As the vacuum pump 10, a low-vacuum pump, such as a scroll pump or a rotary-vane pump, is sufficient. If vacuuming was finished, nitrogen was fed from a gas feed path 9a, and the inside was returned to atmospheric pressure. In this example, the airtight container was once vacuumed, and then returned to atmospheric pressure by nitrogen. However, when the airtight container 1 does not have strength enough to withstand vacuuming, the air may be removed only by flowing nitrogen in a sufficient period of time.

When the airtight container 1 was filled with nitrogen, nitrogen was circulated for about 15 minutes through the circulating path 8. A flow rate of circulation was 3 L/min. An oxygen partial pressure in nitrogen was typically about 10⁻⁶ atm, immediately after introduction from the gas feed path 9, but was lowered to 10⁻²⁵ atm or less while the gas was circulated through the oxygen pump 2.

When the oxygen partial pressure was sufficiently lowered, the plasma generation means 4 was turned on, and nitrogen in which an ultralow oxygen state was achieved, was converted into plasma, and the specimen 6 was irradiated therewith. In this nitrogen, the oxygen partial pressure itself was extremely low, but a total pressure was almost atmospheric pressure. Thus, the specimen was irradiated with atmospheric pressure plasma of the nitrogen in which ultralow oxygen state was achieved.

As can be seen from the phase diagram (cited in Fig. 8 in this application) in Fig. 1(A) in Patent Literature 4, when the oxygen partial pressure is 10⁻²⁷ atm or less, if a temperature of the gas 5 converted into plasma is 180°C or higher, the specimen is warmed to the temperature by being irradiated therewith, and reduction thereof should be able to be made. On the other hand, a temperature of the gas was 80°C or lower in low-power atmospheric pressure plasma used this time. Accordingly, the specimen 6 was heated by the heater equipped in the specimen stage 7.

The specimen was heated to 250°C by the heater, and held for 45 minutes while the specimen was irradiated with atmospheric pressure plasma. Then, the specimen 6 was cooled to room temperature (about 25°C), and then the specimen 6 was taken off from the airtight container 1. A cross section of the specimen 6 having the pattern, as shown in Fig. 7, was measured by a laser microscope (VK-9500, manufactured by Keyence Corporation). Further, when volume resistivity was calculated using electrical resistance measured by the 4-terminal method, the resistivity was 2.7 µΩ•cm. This value is about 1.6 times 1.7 µΩ•cm of volume resistivity of bulk copper at 20°C, and is significantly low. Moreover, when the cross section of the specimen was cut out by a focused ion beam (FIB) processing device (FB-2100, manufactured by Hitachi High-Technologies Corporation), and observed by a scanning ion microscope, the cross section was as shown in Fig. 8. When a cross section prepared by digging deeper the specimen from a surface by FIB is observed, with an original surface being spread in front toward us, the cross section cannot be observed directly from front, and therefore the cross section should be inevitably inclined, and observed. In this photograph, the cross section was inclined at 45 degrees. Thus, in order to meet length scales in a horizontal direction and in a vertical direction, the original photograph was elongated 1.41 times in the vertical direction and shown. A part photographed black in a lower part of the photograph shows a glass substrate. In an upper part thereof, semi-cylindrical (half-long elliptical) parts having various contrasts, show parts in which the copper fine particles were processed. A darkly-observed thin layer thereon shows a platinum layer a film of which was formed by sputtering immediately before FIB for antistatic purpose of the specimen. A part in which whitish particles are visible thereon shows a surface of the above-described platinum layer. That is, this part is not the cross section any more, and is a surface on a side far from the cross section. If the photograph is observed, it is known that sintering progresses even at a low temperature of 250°C, and nanoparticles of the raw material achieve grain growth to a size of several tens of times the original size. Moreover, no voids were observed among the particles, which means a significantly dense structure. When electrical resistivity of this specimen was re-measured after 2 months, the resistivity was agreed within an error range. It is considered that the particles were significantly grown in a diameter thereof and no voids were found, and therefore a problem of a resistance rise by spontaneous oxidation does not exist.

### [Example 2]

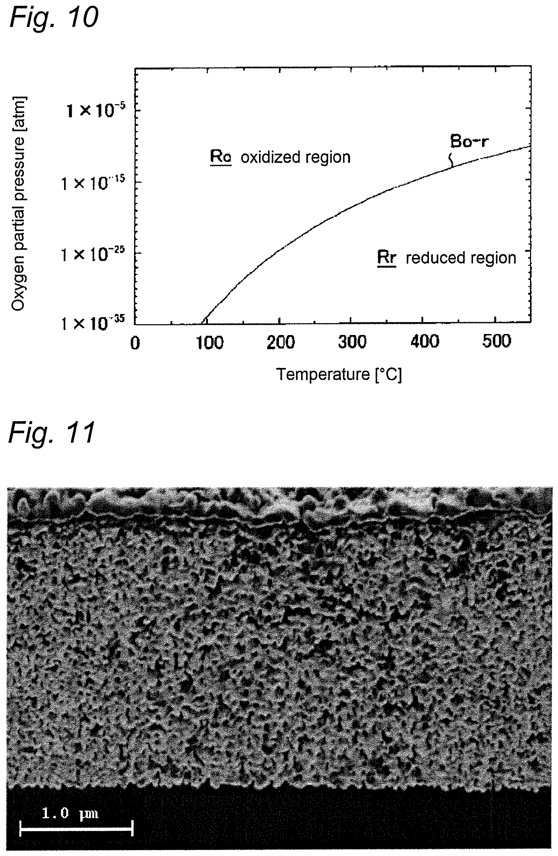

A specimen was provided in the manner same as in Example 1, and organic-matter-removal treatment, under an oxygen flow, was applied under the same conditions. Then, an inside of the airtight container 1 was replaced by nitrogen in the manner same as in Example 1. Then, nitrogen was circulated for about 15 minutes through the circulating path 8, and an oxygen partial pressure was lowered to 10⁻²⁷ atm or less. As can be seen from the phase diagram (Fig. 10) in Fig. 1(A) in Patent Literature 4, when the oxygen partial pressure is 10⁻²⁷ atm or less, if a temperature of the specimen is 180°C or higher, reduction thereof should be able to be made. Therefore, a temperature of the specimen stage 7 was set to 180°C. The specimen was held for 45 minutes in this state while the specimen was irradiated with atmospheric pressure plasma. When volume resistivity of the specimen taken out therefrom was measured in the manner same as in Example 1, the resistivity was 5.0 µΩ•cm. Accordingly, it was found that the specimen would be reduced to a significant degree, even by calcination at a low temperature of 180°C.

### [Example 3]

A specimen was provided in the manner same as in Example 1, and the organic-matter-removal treatment, under an oxygen flow, was applied at 350°C for 45 minutes. Then, the inside of the airtight container 1 was replaced by nitrogen in the manner same as in Example 1. Then, nitrogen was circulated for about 15 minutes through the circulating path 8, and an oxygen partial pressure was lowered to 10⁻²⁷ atm or less. As can be seen from the phase diagram (Fig. 10) in Fig. 1(A) in Patent Literature 4, when the oxygen partial pressure is 10⁻²⁷ atm or less, if a temperature of the specimen is 180°C or higher, reduction thereof should be able to be made. Therefore, a temperature of the specimen stage 7 was set to 180°C. Then, electric current was passed through the heater 12 for gas, so as to be 168°C in a temperature of the gas at an outlet of the heater. The specimen was held for 90 minutes in this state while the specimen was irradiated with atmospheric pressure plasma. When volume resistivity of the specimen taken out therefrom was measured in the manner same as in Example 1, the resistivity was 2.6 µΩ•cm. Further, when a cross section of this specimen was observed in the manner same as in Example 1, the cross section was observed as shown in Fig. 9, and it was found that the specimen was completely sintered. That is, the specimen would be completely sintered, even by calcination at a low temperature of 180°C, by using together the heater for gas. Thus, it was found that a process in which the device of the present invention would be used can be applied to various plastic substrates including PEN.

### [Comparative Example]

Copper fine particles were processed in the manner same as in Example 1, except that no irradiation with plasma by the plasma generation means was performed. As a result, almost no grain growth of fine particles was observed, and the resultant specimen was in a state in which a large number of voids remained among the fine particles (see Fig. 11).

### REFERENCE SIGNS LIST

- 1: Airtight container
- 2: Oxygen pump
- 3: Circulation means
- 4: Plasma generation means
- 5: Gas converted into plasma
- 6: Specimen
- 7: Specimen stage
- 8: Circulating path
- 9: Gas feed path
- 10: Vacuum pump
- 11: Liquid droplet
- 12: Heater for gas
- 13: Gas inlet
- 14: Heater element
- 21: Zirconia solid electrolyte body
- 22, 23: Porous electrodes
- 41a, 41b: Electrodes
- 42: Introduction pipe
- 43: Voltage applying means
- 44: Gas converted into plasma
- 100: Superfine fluid jet
- 200: Nozzle having superfine diameter
- 101: Nozzle body
- 102: Electrode (metal wire)
- 103: Liquid
- 104: Shield rubber
- 105: Nozzle clamp
- 106: Holder
- 107: Pressure regulator
- 108: Pressure tube
- 109: Computer
- 110: Generator (voltage applying means)
- 111: High-voltage amplifier
- S: Substrate

## Claims

1. A sintering device for metal fine particles, comprising:
an airtight container (1) for housing a specimen (6) thereinside;
an oxygen pump (2) for extracting oxygen molecules from a gas discharged from the airtight container (1);
a circulation means (3) for returning the gas into the airtight container (1); and
a plasma generation means (4) present inside the airtight container (1) for converting the gas returned from the circulation means (3) into plasma and exposing the specimen (6) thereto;
wherein the circulation means (3) is provided outside the airtight container (1); or
wherein the circulation means (3) is provided inside the airtight container (1);
wherein the plasma generation means (4) is an atmospheric pressure plasma unit that utilizes a total pressure of the gas returned from the circulation means and converted into plasma between 0.1 atm or more and less than 10 atm in terms of absolute pressure;
wherein the atmospheric pressure plasma unit (4) comprises a voltage applying means (43) and a pipe (42) with electrodes (41a) and (41b) facing each other being fixed in a place near an outlet of the pipe (42) so that the plasma generated between the electrodes (41a) and (41b) can be blown onto the specimen (6) in the form of being jetted from the outlet of the pipe (42); or
wherein the atmospheric pressure plasma unit comprises a high frequency and high voltage applying means in a position different from the outlet of the gas introduction pipe (42) to generate plasma by electromagnetic induction so that the plasma generated can be blown onto the specimen (6); and
wherein the sintering device has a structure that forms a closed loop through which the used gas is returned to the oxygen pump (2).

2. The device according to claim 1, further comprising:
a heater (12) for heating the gas returned from the circulation means (3).

3. The device according to claim 1 or 2, comprising a specimen stage (7) for holding the specimen (6) inside the airtight container (1).

4. The device according to claim 3, wherein the specimen stage (7) includes a heater for heating the specimen.

5. The device according to any one of claims 1 to 4, wherein the circulation means (3) pressurizes the gas discharged from the airtight container (1) and returns the gas into the airtight container (1).

6. The device according to any one of claims 1 to 5, further comprising a nitrogen-containing gas feed path (9).

7. The device according to any one of claims 1 to 6, further comprising a partial pressure control unit that controls an oxygen partial pressure in the gas returned into the airtight container (1) to 10⁻²⁵ atm or less.

8. The device according to any one of claims 1 to 7, wherein the oxygen pump (2) comprises a solid electrolyte body (21) having oxygen ion conductivity and electrodes (22, 23) arranged inside the body and outside the body.

9. The device according to claim 8, wherein the solid electrolyte body (21) is made of stabilized zirconia.

10. The device according to claim 8 or 9, wherein the electrode (22, 23) is a porous electrode along the surfaces of the solid electrolyte body (21).

## Patentansprüche

1. Sintervorrichtung für Metallfeinpartikel, umfassend:
einen luftdichten Behälter (1) zum Aufnehmen einer Probe (6) darin;
eine Sauerstoffpumpe (2) zum Extrahieren von Sauerstoffmolekülen aus einem Gas, das aus dem luftdichten Behälter (1) abgelassen wird;
eine Zirkulationseinrichtung (3) zum Zurückführen des Gases in den luftdichten Behälter (1); und
eine Plasmaerzeugungseinrichtung (4), die in dem luftdichten Behälter (1) vorhanden ist, um das von der Zirkulationseinrichtung (3) zurückgeführte Gas in Plasma umzuwandeln und die Probe (6) diesem auszusetzen;
wobei die Zirkulationseinrichtung (3) außerhalb des luftdichten Behälters (1) vorgesehen ist; oder
wobei die Zirkulationseinrichtung (3) innerhalb des luftdichten Behälters vorgesehen ist (1);
wobei die Plasmaerzeugungseinrichtung (4) eine Atmosphärendruck-Plasmaeinrichtung ist, bei der ein Gesamtdruck des Gases, das aus der Zirkulationseinrichtung zugeführt und in Plasma umgewandelt wird, zwischen 0,1 atm oder mehr und weniger als 10 atm, ausgedrückt als absoluter Druck, verwendet wird;
wobei die Atmosphärendruck-Plasmaeinrichtung (4) eine Spannungsanlegeeinrichtung (43) und ein Rohr (42) mit Elektroden (41a) und (41b) umfasst, die einander gegenüber angeordnet sind und an einem Ort in der Nähe von einem Auslass des Rohrs (42) fixiert sind, so dass das Plasma, das zwischen den Elektroden (41a) und (41b) erzeugt wird, auf die Probe (6) in der Form geblasen werden kann, in der es aus dem Auslass des Rohres (42) ausgestoßen wird, oder
wobei die Atmosphärendruck-Plasmaeinrichtung eine Hochfrequenz- und Hochspannungseinrichtung in einer anderen Position umfasst, als dem Auslass des Gaseinleitungsrohrs (42), um durch magnetische Induktion Plasma zu erzeugen, so dass das erzeugte Plasma auf die Probe (6) geblasen werden kann; und
wobei die Sinter-Einrichtung eine Struktur aufweist, die eine geschlossene Schleife bildet, durch die das verwendete Gas zu der Sauerstoffpumpe (2) zurückgeführt wird.

2. Vorrichtung nach Anspruch 1, weiter umfassend: eine Heizvorrichtung (12) zum Erwärmen des Gases, das von der Zirkulationseinrichtung (3) zurückgeführt wird.

3. Vorrichtung nach Anspruch 1 oder 2, umfassend einen Probenhalter (7) zum Halten der Probe (6) im Inneren des luftdichten Behälters (1).

4. Vorrichtung nach Anspruch 3, wobei der Probenhalter (7) eine Heizvorrichtung zum Erwärmen der Probe umfasst.

5. Vorrichtung nach einem der Ansprüche 1 bis 4, wobei die Zirkulationseinrichtung (3) das Gas unter Druck setzt, das von dem luftdichten Behälter (1) abgelassen wird, und das Gas in den luftdichten Behälter (1) zurückführt.

6. Vorrichtung nach einem der Ansprüche 1 bis 5, die ferner eine Zufuhrleitung (9) für stickstoffhaltiges Gas umfasst.

7. Vorrichtung nach einer der Ansprüche 1 bis 6, ferner umfassend eine Kontrolleinheit für Partialdruck, die den Sauerstoffpartialdruck in dem zu dem luftdichten Behälter (1) zurückgeführten Gas auf 10⁻²⁵ atm oder weniger einstellt.

8. Vorrichtung nach einem der Ansprüche 1 bis 7, wobei die Sauerstoffpumpe (2) einen festen Elektrolyt-Körper (21) mit Sauerstoffionen-Leitfähigkeit und Elektroden (22, 23) umfasst, die innerhalb des Körpers und außerhalb des Körpers angeordnet sind.

9. Vorrichtung nach Anspruch 8, wobei der feste Elektrolyt-Körper (21) aus stabilisiertem Zirkonia hergestellt ist.

10. Vorrichtung nach Anspruch 8 oder 9, wobei die Elektrode (22, 23) eine poröse Elektrode entlang den Oberflächen des festen Elektrolyt-Körpers (21) ist.

## Revendications

1. Dispositif de frittage pour particules fines métalliques, comprenant :
un récipient (1) étanche à l'air pour y loger un échantillon (6) ;
une pompe à oxygène (2) pour extraire des molécules d'oxygène d'un gaz évacué hors du récipient (1) étanche à l'air ;
un moyen de circulation (3) pour renvoyer le gaz jusque dans le récipient (1) étanche à l'air ; et
un moyen de génération de plasma (4) présent à l'intérieur du récipient (1) étanche à l'air pour convertir en plasma le gaz renvoyé depuis le moyen de circulation (3) et pour exposer l'échantillon (6) audit plasma ;
dans lequel
le moyen de circulation (3) est prévu à l'extérieur du récipient (1) étanche à l'air ; ou
le moyen de circulation (3) est prévu à l'intérieur du récipient (1) étanche à l'air ;
le moyen de génération de plasma (4) est une unité de plasma à pression atmosphérique qui utilise une pression totale du gaz renvoyé depuis le moyen de circulation et converti en plasma entre 0,1 atm ou plus et moins de 10 atm en termes de pression absolue ;
l'unité de plasma à pression atmosphérique (4) comprend un moyen d'application de tension (43) et un tube (42) ayant des électrodes (41a) et (41b) se faisant face et fixées à un endroit proche d'une sortie du tube (42), de telle sorte que le plasma généré entre les électrodes (41a) et (41b) puisse être soufflé sur l'échantillon (6) en étant éjecté hors de la sortie du tube (42) ; ou
l'unité de plasma à pression atmosphérique comprend un moyen d'application de haute fréquence et de haute tension dans une position différente de celle de la sortie du tube d'introduction de gaz (42) pour générer un plasma par induction électromagnétique, de sorte que le plasma généré puisse être soufflé sur l'échantillon (6) ; et
le dispositif de frittage présente une structure qui forme une boucle fermée par laquelle le gaz utilisé est renvoyé à la pompe à oxygène (2).

2. Dispositif selon la revendication 1, comprenant en outre :
un élément chauffant (12) pour chauffer le gaz renvoyé depuis le moyen de circulation (3).

3. Dispositif selon la revendication 1 ou 2, comprenant en outre un porte-échantillon (7) pour maintenir l'échantillon (6) à l'intérieur du récipient (1) étanche à l'air.

4. Dispositif selon la revendication 3,
dans lequel le porte-échantillon (7) comprend un élément chauffant pour chauffer l'échantillon.

5. Dispositif selon l'une des revendications 1 à 4,
dans lequel le moyen de circulation (3) pressurise le gaz évacué hors du récipient (1) étanche à l'air et renvoie le gaz jusque dans le récipient (1) étanche à l'air.

6. Dispositif selon l'une des revendications 1 à 5, comprenant en outre un chemin d'alimentation en gaz contenant de l'azote (9).

7. Dispositif selon l'une des revendications 1 à 6, comprenant en outre une unité de commande de la pression partielle qui commande à 10⁻²⁵ atm ou moins une pression partielle d'oxygène dans le gaz renvoyé jusque dans le récipient (1) étanche à l'air.

8. Dispositif selon l'une des revendications 1 à 7,
dans lequel la pompe à oxygène (2) comprend un corps d'électrolyte solide (21) ayant une conductivité pour les ions oxygène et des électrodes (22, 23) disposées à l'intérieur du corps et à l'extérieur du corps.

9. Dispositif selon la revendication 8,
dans lequel le corps d'électrolyte solide (21) est constitué de zircone stabilisée.

10. Dispositif selon la revendication 8 ou 9,
dans lequel l'électrode (22, 23) est une électrode poreuse le long des surfaces du corps d'électrolyte solide (21).
